Europäisches Patentamt

European Patent Office

Office européen des brevets

(19)

(11) **EP 0 639 308 B1**

(12) **EUROPÄISCHE PATENTSCHRIFT**

(45) Veröffentlichungstag und Bekanntmachung des Hinweises auf die Patenterteilung:
**06.03.1996 Patentblatt 1996/10**

(21) Anmeldenummer: **93911430.2**

(22) Anmeldetag: **03.05.1993**

(51) Int Cl.$^6$: **H03K 17/687**, H02M 3/155

(86) Internationale Anmeldenummer:
**PCT/DE93/00386**

(87) Internationale Veröffentlichungsnummer:
**WO 93/22835 (11.11.1993 Gazette 1993/27)**

(54) **SCHALTUNGSANORDNUNG ZUM ANSTEUERN EINES MOS-FELDEFFEKTTRANSISTORS**

DRIVE CIRCUITRY FOR A MOS FIELD EFFECT TRANSISTOR

CIRCUIT POUR COMMANDER UN TRANSISTOR A EFFET DE CHAMP MOS

(84) Benannte Vertragsstaaten:
**DE ES FR GB IT**

(30) Priorität: **07.05.1992 DE 4215042**

(43) Veröffentlichungstag der Anmeldung:
**22.02.1995 Patentblatt 1995/08**

(73) Patentinhaber: **Siemens Nixdorf Informationssysteme Aktiengesellschaft D-33102 Paderborn (DE)**

(72) Erfinder: **POLLMEIER, Werner D-4837 Verl 1 (DE)**

(74) Vertreter: **Fuchs, Franz-Josef, Dr.-Ing. et al Postfach 22 13 17 D-80503 München (DE)**

(56) Entgegenhaltungen:
**US-A- 3 654 490          US-A- 4 859 927 US-A- 4 940 906**

- **PATENT ABSTRACTS OF JAPAN vol. 5, no. 181 (E-83)(853) 20. November 1981 & JP-A-56 109 037 ( NIPPON DENSHI K.K. ) 29 August 1981, abstract**
- **COMPUTER DESIGN Bd. 20, Nr. 11, 1. November 1981, WINCHESTER, MASS,US Seiten 233 - 240 B. ROEHR 'VMOS TRANSISTORS INTERFACE ICS T0 HIGH POWER LOADS' figures 7-9**

**Beschreibung**

Die Erfindung betrifft eine Schaltungsanordnung zum Ansteuern eines MOS-Feldeffekttransistors als Leistungsschaltelement in einem nach dem Zerhackerprinzip arbeitenden Gleichspannungswandler, wobei der Sourceanschluß des MOS-Feldeffekttransistors durch dessen Schalten unterschiedliches Potential annimmt.

In heutigen tragbaren Personalcomputern erfolgt die Stromversorgung der Elektronik als auch der Laufwerke über an sich bekannte Schaltregler. Diese verfügen über einen hohen Wirkungsgrad. Der Flußspannungsverlust eines Schaltreglers mit bipolarer Schaltstufe beträgt aber ca. 1 Volt. Bei einer kleinen Eingangsspannung von ungefähr +6 V und einer gewünschten Ausgangsspannung von +5 V sind diese Verluste relativ hoch. Durch den Einsatz eines MOS-Feldeffekttransistors als Spannungsunterbrecher mit niedrigem Einschalt-Widerstand sind diese Verluste stark reduzierbar.

Zur Ansteuerung niederohmiger N-Kanal-Feldeffekttransistoren ist z.B. ein Gate-Treiber erforderlich, der die Gate-Source-Spannungen von

10 V $\leq$ UGS $\leq$ 20 V ($\triangleq$ Feldeffekttransistor ("Ein")

-20 V $\leq$ UGS $\leq$ 2 V ($\triangleq$ Feldeffekttransistor ("Aus")

erzeugt.

Soll ein Eingangsspannungsbereich von UE = + 5,5 V bis + 15 V realisiert werden, verändert sich durch das Schalten des MOS-Feldeffekttransistors seine Sourcespannung beispielsweise von

US $\approx$ - 0,5 V ( $\triangleq$ Feldeffekttransistor ("Aus")nach

US $\approx$ + 5,5 V bis + 15 V ($\triangleq$ Feldeffekttransistor ("Ein").

Bei einer Eingangsspannung von UE = + 15 V beträgt die Einschalt-Gatespannung

UGSmin + UEmax = 10 V + 15 V = 25 V $\leq$ UGon $\leq$ 35 V = 20 V + 15 V = UGSmax + UEmax

Bei einer Eingangsspannung von UE = + 5,5 V beträgt die Einschalt-Gatespannung

UGSmin + UEmin = 10 V + 5,5 V = 15,5 V $\leq$ UGon $\leq$ 25,5 V = 20 V + 5,5 V = UGmax + UEmin

Die Gatesteuerspannung für den gewählten Eingangsspannungsbereich von UE = +5,5 V bis 15 V muß somit zwischen UGonmin (UE = +15 V) = 25 V $\leq$ UGon $\leq$ 25,5 V = UGonmax (UE = +5,5 V) liegen.

Übliche integrierte Gatetreiber sind in ihrer Spannung auf Umax = 20 V begrenzt und haben einen nachteilhaft hohen Eigenstromverbrauch. Dieser ist gegeben durch die schnelle Umladung interner Kapazitäten mit großem Spannungshub und hoher Flankensteilheit am Ausgang. Eine hohe Flankensteilheit ist wichtig, um geringe Schaltverluste im MOS-Feldeffekttransistor zu erhalten.

Eine Schaltungsanordnung zur Ansteuerung eines MOS-Feldeffekttransistors innerhalb eines Gleichspannungswandlers ist beispielsweise aus US-A-4 859 927 bekannt. Diese arbeitet mit einer Komplementärtransistorstufe, über die der MOS-Feldeffekttransistor angesteuert wird. Die Komplementärtransistorstufe ist dabei mit wenigstens einer Seite an eine Versorgungsspannung angeschlossen. Die Basisanschlüsse der Komplementärtransistoren sind mit einer Steuerschaltung verbunden, die die Komplementärtransistoren abhängig von einer vorgegebenen Ausgangsspannung des Gleichspannungswandlers ansteuert.

Aus dem Dokument US-A-3 654 490 ist eine weitere Schaltungsanordnung zum Ansteuern eines MOS-Feldeffekttransistors mit einem Paar komplementärer Transistoren bekannt. Bei dieser Schaltungsanordnung sind die Basen der komplementären Transistoren nicht direkt miteinander verbunden, sondern sie werden getrennt über gleichphasige Steuersignale angesteuert. Dabei ist einem der beiden komplementären Transistoren ein Phasenumkehrtransistor zugeordnet.

In der Regel weisen Schaltregler-Bausteine eine übliche relative Einschaltdauer von 90% auf. Wünschenswert wäre aber eine Einschaltdauer von 100%. Zwar weist der oben erwähnte Phasenumkehrtransistor eine Speicherzeit auf, durch die die Einschaltdauer der zugehörigen Schaltungsanordnung beeinflußt werden kann. Es sind aber keine weiteren Maßnahmen angegeben, um eine 100%-ige Einschaltdauer tatsächlich sicherzustellen.

Aufgabe der Erfindung ist daher, eine Schaltungsanordnung der Eingangs genannten Art anzugeben, durch die eine 100%-ige Einschaltdauer sichergestellt werden kann.

Erfindungsgemäß wird diese Aufgabe durch die im kennzeichnenden Teil des Anspruchs 1 angegebenen Merkmale gelöst.

Eine danach ausgebildete Schaltungsanordnung erzeugt Ansteuersignale für einen MOS-Feldeffekttransistor mit hoher Flankensteilheit und geringem Eigenstrombedarf. Der geringe Eigenstrombedarf ergibt sich aus einer Stromkopplung mit geringem Spannungshub, durch den die verschiedenen Kapazitäten in der Schaltungsanordnung nur mehr geringfügig umgeladen werden müssen. Für den geringen Spannungshub trägt die am Eingang der Schaltungsanordnung vorgesehene Spannungsbegrenzungsschaltung bei. Außerdem ist vorteilhaft, daß die Schaltungsanordnung mit einem konstanten Steuerstrom arbeitet, der unabhängig vom Wert einer ersten Hilfsspannungsquelle ist.

Die Schaltungsanordnung hat eine einschaltzeitverzögernde Wirkung, wodurch die maximale Einschaltdauer eines verwendeten Schaltregler-Bausteins, wie z.B. der Schaltreglerbaustein TL 494 von Texas Instruments oder MC 34 060 von Motorola, erhöht wird. Die einschaltverzögernde Wirkung wird durch die sperrverzögernde Wirkung eines Vorstufentransistors bewerkstelligt, der hier als Phasenumkehrtransistor arbeitet. Für eine entscheidende Erhöhung der Einschaltdauer trägt aber ein an der Basis des zweiten weiteren Transistors angeschlossener Kondensator bei, durch den die Einschaltverzögerung der Schaltungsanordnung zusätzlich soweit erhöht werden kann, daß die Einschaltdauer 100 % beträgt.

Vorteilhafte Ausgestaltungen der Erfindung sind in den Unteransprüchen gekennzeichnet.

Durch eine höhere Stromschaltschwelle des ersten weiteren Transistors gegenüber dem Phasenumkehrtransistor wird ein gleichzeitiges Schalten der Komplementärtransistoren verhindert.

Eine Zenerdiode stellt eine einfache Lösung für die Realisierung einer Spannungsbegrenzungsschaltung dar.

Darlington-Transistoren eignen sich besonders für hohe Ausgangsströme.

Ein niederohmiger Strombegrenzungswiderstand im Kollektorzweig des Eingangstransistors verbessert das Ausfallverhalten der Schaltungsanordnung im gestörten Betrieb.

Ein hochohmiger Ableitwiderstand am Ausgang der Schaltungsanordnung, der parallel zur Gate-Source-Strecke des MOS-Feldeffekttransistors geschaltet wird, erhöht die Arbeitssicherheit der Schaltungsanordnung.

Entsättigungsdioden für die Komplementärstufentransistoren gewähren ein niederohmiges Durchschalten der Komplementärstufentransistoren mit geringer Sättigungsspannung.

Die Erfindung wird nachfolgend anhand einer Zeichnung näher erläutert. Darin zeigen

Figur 1 ein Ausführungsbeispiel für die Anwendung einer Schaltungsanordnung zum Ansteuern eines MOS-Feldeffekttransistors gemäß dem Stand der Technik,

Figur 2 eine Schaltungsanordnung zum Ansteuern eines MOS-Feldeffekttransistors gemäß der Erfindung,

Figur 3 eine verbesserte Ausführungsform einer Schaltungsanordnung gemäß Figur 2, und

Figur 4 ein Ausführungsbeispiel für die Anwendung einer Schaltungsanordnung zum Ansteuern eines MOS-Feldeffekttransistors gemäß der Figuren 2 und 3.

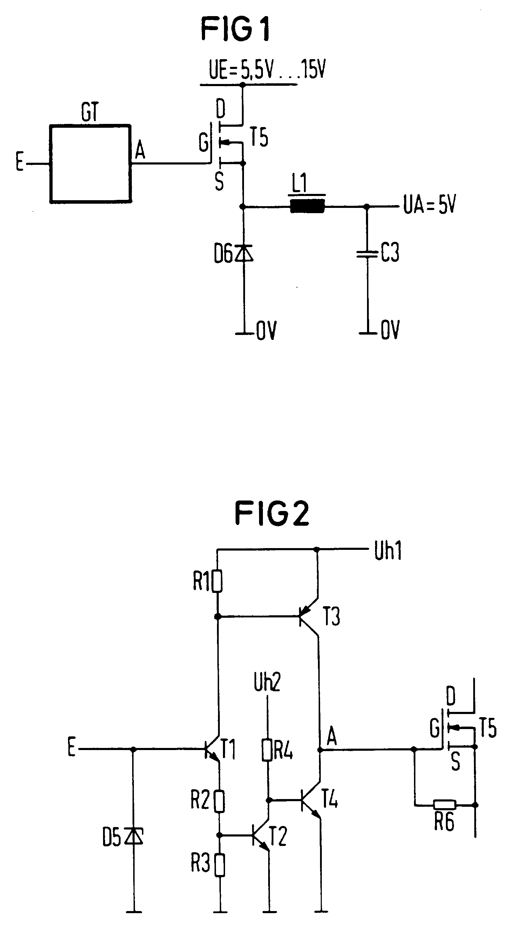

Figur 1 zeigt einen an sich bekannten Abwärtsschaltregler bestehend aus einem als Spannungsunterbrecher wirkenden MOS-Feldeffekttransistor T5 mit einem Gate G, einer Drain D und einer Source S, einer Freilaufdiode D6, einer Siebdrossel L1 und einem Glättungskondensator C3, die in der dargestellten Weise zusammengeschaltet sind. Der als Spannungsunterbrecher wirkende MOS-Feldeffekttransistor T5 wird am Gate G des MOS-Feldeffekttransistors T5 über einen ebenfalls an sich bekannten Gatetreiber GT mit einem Steuereingang E und einem Ausgang A angesteuert. Das hier gezeigte Ausführungsbeispiel ist auf ein Massepotential bezogen, das mit 0 V gekennzeichnet ist. An der Drain D des MOS-Feldeffekttransistors T5 liegt eine Eingangsspannung UE mit einem Wert von 5,5 V bis 15 V an. Die Eingangsspannung UE wird zu einer Ausgangsspannung UA mit einem Wert von 5 V ausgeregelt.

Für die Beschreibung der nachfolgenden Figuren werden für gleiche Bauteile jeweils die gleichen Bezugszeichen unabhängig davon, ob sie schon angesprochen worden sind oder nicht, verwendet und es werden auch die gleiche Eingangsspannung UE und die gleiche Ausgangsspannung UA zugrundegelegt.

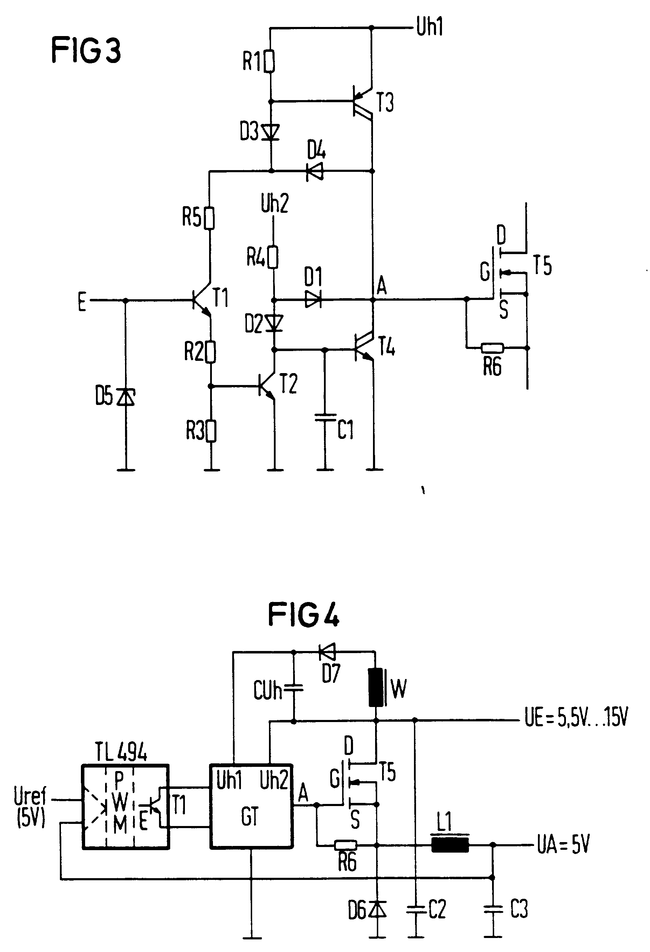

Die Schaltungsanordnungen in den Figuren 2 und 3 stellen einen Gatetreiber GT dar, wie er in der Figur 1 und später auch in der Figur 4 eingesetzt werden kann. Die Schaltungsanordnung nach Figur 3 stellt dabei eine verbesserte Ausführungsform gegenüber der Schaltungsanordnung nach Figur 2 dar. Da es sich im Grunde jeweils um die gleiche Schaltungsanordnung handelt, werden beide Schaltungsanordnungen nach den Figuren 2 und 3 zusammen beschrieben.

Die Schaltungsanordnung weist einen Eingangstransistor T1 auf, der für eine Stromkopplung zwischen einem vorgeschalteten, in der Figur 4 näher dargestellten Schaltregler-Baustein und der Schaltungsanordnung zuständig ist. Dabei kann auch anstelle des Eingangstransistors T1 der Ausgangstransistor des vorgeschalteten Schaltregler-Bausteins (Figur 4) benutzt werden. Desweiteren weist die Schaltungsanordnung einen Phasenumkehrtransistor T2 und eine Komplementärstufe gebildet aus einem ersten und einem zweiten weiteren Transistor T3, T4 auf. Der Phasenumkehrtransistor T2 ist dem zweiten weiteren Transistor T4 der Komplementärstufe vorgeschaltet.

Die beiden weiteren Transistoren T3, T4 schalten bis zur Sättigungsspannung durch. Für hohe Ausgangsströme eignen sich anstelle einstufiger weiterer Transistoren T3, T4 Darlington-Transistoren (Figur 3).

Die Basis des Eingangstransistors T1 bildet den Steuereingang E der Schaltungsanordnung. Am Steuereingang E der Schaltungsanordnung ist eine Spannungsbegrenzungsschaltung D5 angeschlossen, die durch eine in Sperrichtung gepolte Zenerdiode gebildet ist.

Im Ausgangskreis des Eingangstransistors befindet sich eine Serienschaltung bestehend aus einem ersten, zweiten und dritten Widerstand R1, R2, R3, von denen der erste Widerstand R1 auf der Kollektorseite und der zweite und dritte Widerstand R2, R3 auf der Emitterseite des Eingangstransistors T1 angeordnet sind.

Der erste Widerstand R1 weist eine freie Anschlußseite auf, an die eine erste Hilfsspannungsquelle Uh1 angeschlossen ist. Der zweite Widerstand R2 ist mit dem Emitter des Eingangstransistors T1 verbunden. Der dritte Widerstand R3 ist zwischen dem zweiten Widerstand R2 und dem Massepotential der Schaltungsanordnung angeordnet.

Die Basis des Phasenumkehrtransistors T2 ist mit einem Mittelanschluß zwischen dem zweiten und dritten Widerstand R2, R3 verbunden. Der Kollektor des Phasenumkehrtransistors T2 ist über einen vierten Widerstand R4 an eine zweite Hilfsspannungsquelle Uh2 angeschlossen.

Der erste weitere Transistor T3 ist mit seiner Basis an der der freien Anschlußseite des ersten Widerstandes R1 gegenüberliegenden Anschlußseite und der zweite weitere Transistor T4 ist mit seiner Basis am Kollektor des Phasenumkehrtransistors T2 angeschlossen. Die Durchgangsstrecken der beiden weiteren Transistoren T3, T4 sind in der Weise untereinander sowie mit der ersten Hilfsspannungsquelle Uh1, dem Ausgang A und dem Massepotential der Schaltungsanordnung verbunden, daß der Emitter des ersten weiteren Transistors T3 mit der ersten Hilfsspannungsquelle Uh1, der Kollektor des ersten weiteren Transistors T3 mit dem Ausgang A der Schaltungsanordnung und gleichzeitig mit dem Kollektor des zweiten weiteren Transistors T4 und der Emitter des zweiten weiteren Transistors T4 mit dem Massepotential der Schaltungsanordnung verbunden sind.

An den Ausgang A der Schaltungsanordnung ist die Basis des MOS-Feldeffekttransistors T5 angeschlossen.

Die zweite Hilfsspannungsquelle Uh2 liefert, wie Figur 4 zeigt, die zu regelnde Eingangsspannung UE mit einem Spannungswert zwischen 5,5 V bis 15 V. Die erste Hilfsspannungsquelle Uh1 liefert, wie ebenfalls Figur 4 zeigt, eine zur Spannung der zweiten Hilfsspannungsquelle Uh2 um einen vorgegebenen Betrag aufgestockte Spannung.

Der Eingangstransistor T1, der Phasenumkehrtransistor T2 und der zweite weitere Transistor T4 sind durch NPN-Transistoren und der erste weitere Transistor T3 ist durch einen PNP-Transistor gebildet.

Gemäß Figur 3 kann im Kollektorzweig des Eingangstransistors T1 unmittelbar dem Kollektor des Eingangstransistors T1 zugeordnet ein niederohmiger Strombegrenzungswiderstand R5 angeordnet sein, der im Fehlerfall, z.B. im Kurzschlußfall, zur Strombegrenzung dient. Desweiteren kann an der Basis des zweiten weiteren Transistors T4 ein Kondensator C1 (Figur 3) angeschlossen und am Ausgang A ein Ableitwiderstand R6 (Figuren 1 und 2) mit einer freien Anschlußseite für den Anschluß an die Source S des MOS-Feldeffekttransistors T5 vorgesehen sein. Außerdem können Entsättigungsdioden D1, D2; D3, D4 - wie in Figur 3 dargestellt - für die beiden weiteren Transistoren T3, T4 verwendet sein.

Der erste und dritte Widerstand R1 und R3 bestimmen die Stromschaltschwellen des ersten weiteren Transistors T3 und des Phasenumkehrtransistors T2. Die Widerstände sind dabei in der Weise zu wählen, daß die Stromschaltschwelle des Phasenumkehrtransistors T2 niedriger ist als die Stromschaltschwelle des ersten weiteren Transistors T3. Als Referenzspannungsbezug der Stromschaltschwellen dient der jeweilige Basis-Emitter-Diodenschwellwert.

Der zweite Widerstand R2 und eine Basisspannungsbegrenzung, z.B. durch die Zenerdiode D5 am Eingangstransistor T1, begrenzen den Steuerstrom am Eingang E der Schaltungsanordnung.

Im vorgeschalteten Schaltregler-Baustein (Figur 4) erfolgt die Basisspannungsbegrenzung durch die eigene Versorgungsspannung abzüglich einiger interner Schaltstrecken. Vorzugsweise sollte der Spannungsbegrenzungswert der Basis des Eingangstransistors T1 im Sinne eines geringen Spannungshubes und der damit verbundenen geringen kapazitiven Ladeströme klein sein.

In der weiteren Beschreibung werden die einzelnen Schaltphasen der Schaltungsanordnung näher betrachtet.

1. Der MOS-Feldeffekttransistor T5 ist "nicht leitend": Der Eingangstransistor T1 ist hierbei durch eine Basisspannung von ca. 0 V gesperrt. Folglich sperrt auch der Phasenumkehrtransistor T2 und der erste weitere Transistor T3. Der zweite weitere Transistor T4 wird über den vierten Widerstand R4 leitend gesteuert.

2. Der MOS-Feldeffekttransistor T5 wird vom Aus- in den Ein-Zustand gesteuert:
Zunächst wird die Basis des Eingangstransistors T1 positiv gesteuert. Der Emitter vom Eingangstransistor T1 wird positiv und prägt einen Strom im ersten Widerstand R1 und im dritten Widerstand R3 ein. Ab einem Stromwert von I = UBE, T2/R3 (UBE, T2: Basis-Emitterspannung von T2) wird der Phasenumkehrtransistor T2 leitend und sperrt den zweiten weiteren Transistor T4. Ab einem höheren Stromwert von I = UBE, T3/R1 (UBE, T3: Basis-Emitter-Spannung von T3) wird der erste weitere Transistor T3 leitend. Durch die Spannungsbegrenzung über die Zenerdiode D5 und den zweiten Widerstand R2 wird der Strom begrenzt. Aufgrund einer hohen Übersättigung des zweiten weiteren Transistors T4 sperrt dieser langsam. Vorübergehend schalten der erste weitere Transistor T3 und der zweite weitere Transistor T4 gegeneinander. Um die hierdurch auftretende Verlustleistung zu vermeiden, kann der zweite weitere Transistor T4 mittels dem Diodenpaar D1, D2 (Figur 3) ungesättigt betrieben werden.

3. Der MOS-Feldeffekttransistor T5 wird vom Ein- in den Aus-Zustand gesteuert:
Die Basis vom Eingangstransistor T1 wird gegen 0 V gesteuert. Hierbei führt der Eingangstransistor T1 stetig weniger Strom. Zunächst sperrt der erste weitere Transistor T3 wegen seiner hohen Stromschaltschwelle. Danach sperrt der Phasenumkehrtransistor T2 und der zweite weitere Transistor T4 wird leitend.

Bei starker Schaltverzögerung des ersten weiteren Transistors T3 infolge einer Übersättigung können der erste weitere Transistor T3 und der zweite weitere Transistor T4 gegeneinander schalten. Abhilfe schaffen hier die Entsättigungsdioden (D3, D4 (Figur 3). Diese sind in der Regel nicht erforderlich, da der Phasenumkehrtransistor T2 stark übersättigt und eine genügend lange Speicherzeit von ca. 3 µs aufweist. Innerhalb dieser Zeit wird der erste weitere Transistor T3 problemlos über den ersten Widerstand R1 gesperrt.

Die im Phasenumkehrtransistor T2 auftretende Speicherzeit verzögert das Einschalten des zweiten weiteren Transistors T4. Die Folge ist eine verlängerte Einschaltzeit des MOS-Feldeffekttransistors T5. Sie ist erforderlich, um die bei Schaltregler-Bausteinen übliche relative Einschaltdauer von 90 % auf 100 % zu erhöhen. Bei einer Schaltfrequenz von z.B. 50 kHz entspricht die fehlende Einschaltzeit

$$t = 1/50\ kHz \times (100\ \% - 90\ \%)/\ 100\ \% = 2\ \mu s.$$

Durch einen Kondensator C1 an der Basis des zweiten weiteren Transistors T4 läßt sich der zweite weitere Transistor T4 zusätzlich durch die Zeitkonstante R4 x C1 einschaltverzögern. In entgegengesetzter Richtung wird der Kondensator C1 niederohmig über den Phasenumkehrtransistor T2 entladen. Zwischen der Zeit, in der der erste weitere Transistor T3 "aus"- und der zweite weitere Transistor T4 "ein"-geschaltet wird, liegt ein hochohmiger Zustand am Ausgang A der Schaltungsanordnung vor. Dieser Sachverhalt ist jedoch ohne Bedeutung, da kein Gatestrom im MOS-Feldeffekttransistor T5 fließt. Ein zusätzlicher hochohmiger Ableitwiderstand R6 vermeidet den Aufbau einer Gatespannung am MOS-Feldeffekttransistor T5 durch einen möglichen Kollektorreststrom im ersten weiteren Transistor T3 bei fehlender Versorgungsspannung Uh2 am vierten Widerstand R4 (gestörter Betrieb).

Die Zeitkonstante R6/CGS + CGD (CGS, CGD: Kapazität der Gate-Source-, Gate-Drain-Strecke des MOS-Feldeffekttransistors T5) kann so bemessen sein, daß sie im Schaltbetrieb nicht stört. Zum Beispiel kann R6 = 100 kOhm betragen. Bei einer Gatekapazität von CGS + CGD = 5 nF beträgt die Zeitkonstante $\tau$ = 500 µs. Bei einer lückenden Zeit (Zeit, in der die beiden weiteren Transistoren T3, T4 gleichzeitig nicht leitend sind) von t $\approx$ 1 bis 2 µs ist die hohe Zeitkonstante unkritisch.

Die Spannung der zweiten Hilfsspannungsquelle Uh2 am vierten Widerstand R4 kann gleich dem Spannungswert der ersten Hilfsspannungsquelle Uh1 sein. Vorteilhaft ist jedoch wegen der Verlustleistungsreduzierung ein kleiner Spannungswert für die zweite Hilfsspannungsquelle Uh2.

Figur 4 zeigt die Erzeugung einer Ausgangsspannung UA unter Anwendung einer vorbeschriebenen Schaltungsanordnung. Der Leistungskreis der dargestellten Schaltungsanordnung besteht aus dem MOS-Feldeffekttransistor T5, der Freilaufdiode D6, der Siebdrossel L1 und dem Glättungskondensator C3. Wegen vorhandener nachteiliger Eingangsinduktivitäten sind der MOS-Feldeffekttransistor T5 und die Freilaufdiode D6 durch einen Parallelkondensator C2 überbrückt. Die Flußspannung der Freilaufdiode D6 entspricht der Sourcespannung US des MOS-Feldeffekttransistors T5 in dessen "AUS"-Zustand.

Dem MOS-Feldeffekttransistor T5 ist die vorbeschriebene Schaltungsanordnung als Treiberstufe GT vorgeschaltet. Dem Eingang der Treiberstufe ist ein Fehlerverstärker und ein Pulsweitenmodulator PWM mit Ausgangstransistor vorgesetzt, wobei der Ausgangstransistor als Eingangstransistor T1 der Treiberstufe GT verwendet wird. Für den Fehlerverstärker, den Pulsweitenmodulator und den angesprochenen Ausgangstransistor wird der Schaltregler-Baustein TL 494 von Texas Instrument eingesetzt. Der interne Fehlerverstärker bestimmt im Zusammenwirken mit dem Pulsweitenmodulator aus einer Referenzspannung Uref und der rückgeleiteten Ausgangsspannung UA die relative Einschaltdauer des MOS-Feldeffekttransistors T5. Frequenzbestimmende, strombegrenzende und spannungsbestimmende Komponenten sind in der Darstellung nicht aufgeführt. Sie sind in einschlägigen Applikationen der IC-Hersteller beschrieben.

Die Spannung der ersten Hilfsspannungsquelle Uhl wird über die Wicklung W eines separaten Spannungswandlers erzeugt. Sie kann Bestandteil zusätzlich erforderlicher Spannungen im System sein.

Durch Schaltungskomponenten bestehend aus einer Diode D7 und einem Kondensator CUh, die in der dargestellten Weise angeschlossen sind, wird die Spannung des separaten Spannungswandlers auf die Spannung der zweiten Hilfsspannungsquelle Uh2 aufgestockt und als Spannung der ersten Hilfsspannungsquelle Uh1 dem Gatetreiber GT zugeführt.

**Patentansprüche**

1. Schaltungsanordnung zum Ansteuern eines MOS-Feldeffekttransistors (T5) als Leistungsschaltelement in einem nach dem Zerhackerprinzip arbeitenden Gleichspannungswandler, mit einem Paar komplementärer Transistoren gebildet aus zwei weiteren Transistoren (T3, T4), deren Basen ausgehend von einem Eingangstransistor (T1) mit gleichphasigen Steuersignalen angesteuert werden, und mit einer Spannungsbegrenzerschaltung, **dadurch gekennzeichnet,**

daß die Basis des ersten weiteren Transistors (T3) mit dem mit Mitteln (R1) zum Einstellen eines Stromschaltschwellwertes für den ersten weiteren Transistors (T3) in Verbindung stehenden Kollektor des Eingangstransistors (T1) und die Basis des zweiten weiteren Transistors (T4) mit dem mit einer Versorgungsspannung (Uh2) über einen Lastwiderstand (R4) in Verbindung stehenden Kollektor eines Phasenumkehrtransistors (T2) verbunden ist,

daß die Basis des Phasenumkehrtransistors (T2) mit dem mit Mitteln (R2, R3) zum Einstellen eines Stromschaltschwellwertes für den Phasenumkehrtransistor (T2) in Verbindung stehenden Emitter des Eingangstransistors (T1) verbunden ist,

daß zwischen der Basis des zweiten weiteren Transistors (T4) und einem Bezugspotential der Schaltungsanordnung ein Kondensator (C1) für eine gegenüber einer Einschaltverzögerung, die durch eine im Phasenumkehrtransistor (T2) auftretende Speicherzeit bedingt ist, zusätzliche Einschaltverzögerung des zweiten weiteren Transistors (T4) angeordnet ist, und daß die Mittel (R1; R2, R3) zum Einstellen der Stromschaltschwellwerte des ersten weiteren Transistors (T3) und des Phasenumkehrtransistors (T2) derart gewählt sind, daß der Stromschaltschwellwert des Phasenumkehrtransistors (T2) niedriger als der Stromschaltschwellwert des ersten weiteren Transistors (T3) ist.

2. Schaltungsanordnung nach Anspruch 1, **dadurch gekennzeichnet**,
daß zwischen dem ersten und zweiten weiteren Transistor (T3, T4) ein Ausgang (A) der Schaltungsanordnung vorgesehen ist, an den ein hochohmiger Ableitungswiderstand (R6) mit einer freien Anschlußseite für den Anschluß an die Source (S) des MOS-Feldeffekttransistors (T5) angeschlossen ist.

3. Schaltungsanordnung nach einem der vorherigen Ansprüche, **dadurch gekennzeichnet**, daß zwischen der Basis und dem Kollektor des ersten weiteren Transistors (T3) eine Serienschaltung bestehend aus zwei aufeinander zuweisend gepolten Dioden (D3, D4) in der Weise angeordnet ist, daß die Verbindung der Basis des ersten weiteren Transistors (T3) mit dem Kollektor des Eingangstransistors (T1) über eine der Dioden (z.B. D3) hergestellt ist.

4. Schaltungsanordnung nach einem der vorherigen Ansprüche, **dadurch gekennzeichnet**, daß zwischen der Verbindung der Basis des zweiten weiteren Transistors (T4) mit dem Kollektor des Phasenumkehrtransistors (T2) eine Serienschaltung bestehend aus zwei voneinander wegweisend gepolten Dioden (D1, D2) in der Weise angeordnet ist, daß der Kollektor des Phasenumkehrtransistors (T2) und die Basis des zweiten weiteren Transistors (T4) über eine der Dioden (z.B. 2) mit den angepaßten Mitteln (R4), über die eine Verbindung mit der zugeordneten Versorgungsspannung (Uh2) gegeben ist, verbunden ist.

5. Schaltungsanordnung nach einem der vorherigen Ansprüche, **dadurch gekennzeichnet**, daß im Kollektorzweig des Eingangstransistors (T1) unmittelbar dem Kollektor des Eingangstransistors (T1) zugeordnet ein niederohmiger Strombegrenzungswiderstand (R5) angeordnet ist.

6. Schaltungsanordnung nach einem der vorherigen Ansprüche, **dadurch gekennzeichnet**, daß die beiden weiteren Transistoren (T3, T4) durch Darlington Transistoren gebildet sind.

**Claims**

1. Circuit arrangement for driving an MOS field-effect transistor (T5) as a power switching element in a DC/DC voltage converter operating on the chopper principle, having a pair of complementary transistors formed from two further transistors (T3, T4) whose bases are driven with in-phase control signals originating from an input transistor (T1), and having a voltage limiter circuit, characterized in that the base of the first further transistor (T3) is connected to the collector of the input transistor (T1), which collector is connected to means (R1) for setting a current switching threshold value for the first further transistor (T3), and the base of the second further transistor (T4) is connected to the collector of a phase reversing transistor (T2), which collector is connected to a supply voltage (Uh2) via a load resistor (R4),
in that the base of the phase reversing transistor (T2) is connected to the emitter of the input transistor (T1), which emitter is connected to means (R2, R3) for setting a current switching threshold value for the phase reversing transistor (T2),
in that a capacitor (C1) is arranged between the base of the second further transistor (T4) and a reference potential of the circuit arrangement, for a switching-on delay of the second further transistor (T4), which switching-on delay is additional to a switching-on delay which is governed by a storage time occurring in the phase reversing transistor (T2), and in that the means (R1; R2, R3) for setting the current switching threshold values of the first further transistor (T3) and of the phase reversing transistor (T2) are selected in such a manner that the current switching threshold value of the phase reversing transistor (T2) is lower than the current switching threshold value of the first further transistor (T3).

2. Circuit arrangement according to Claim 1, characterized in that an output (A) of the circuit arrangement is provided between the first and the second further transistor (T3, T4), to which output (A) a high-value suppression resistor (R6) is connected, with a free connection side for connection to the source (S) of the MOS field-effect transistor (T5).

3. Circuit arrangement according to one of the preceding claims, characterized in that a series circuit comprising two diodes (D3, D4) which are connected such that they face one another is arranged between the base and the collector of the first further transistor (T3) in such a manner that the connection of the base of the first further transistor (T3) to the collector of the input transistor (T1) is produced via one of the diodes (for example D3).

4. Circuit arrangement according to one of the preceding claims, characterized in that a series circuit comprising two diodes (D1, D2) which are connected pointing away from one another is arranged between the connection of the base of the second further transistor (T4) to the collector of the phase reversing transistor (T2) in such a manner that the collector of the phase reversing transistor (T2) and the base of the second further transistor (T4) are connected via one of the diodes (for example 2) to the matched means (R4) via which a connection to the associated supply voltage (Uh2) is provided.

5. Circuit arrangement according to one of the preceding claims, characterized in that a low-value current limiting resistor (R5), assigned directly to the collector of the input transistor (T1), is arranged in the collector path of the input transistor (T1).

6. Circuit arrangement according to one of the preceding claims, characterized in that the two further transistors (T3, T4) are formed by Darlington transistors.


**Revendications**

1. Montage pour la commande d'un transistor à effet de champ MOS (T5) en tant qu'élément de commutation de puissance dans un transformateur de tension continue, qui travaille selon le principe du hacheur, et comportant un couple de transistors complémentaires, qui sont constitués de deux autres transistors (T3,T4), dont les bases sont commandées à partir d'un transistor d'entrée (T1) par des signaux de commande en phase, et un circuit limiteur de tension, caractérisé par le fait

    que la base du premier autre transistor (T3) est reliée au collecteur du transistor d'entrée (T1), qui est connecté à des moyens (R1) servant à régler une valeur de seuil de commutation de courant pour le premier autre transistor (T3), et la base du second autre transistor (T4) est reliée au collecteur, d'un transistor d'inversion de phase (T2), lequel collecteur est connecté à la tension d'alimentation (Uh2) par l'intermédiaire d'une résistance de charge (R4),

    que la base du transistor d'inversion de phase (T2) est reliée à l'émetteur du transistor d'entrée (T1), qui est relié à des moyens (R2,R3) servant à régler une valeur de seuil de commutation de courant pour le transistor d'inversion de phase (T2),

    qu'entre la base du second autre transistor (T4) et un potentiel de référence du montage est disposé un condensateur (C1) pour obtenir un retard supplémentaire de mise à l'état conducteur du second autre transistor (T4), par rapport à un retard de mise à l'état conducteur, qui est conditionné par une durée de mémorisation qui apparaît dans le transistor d'inversion de phase (T2), et

    que les moyens (R1;R2,R3) servant à régler les valeurs de seuil de commutation de courant du premier autre transistor (T3) du transistor d'inversion de phase (T2) sont choisis de telle sorte que la valeur de seuil de commutation de courant du transistor d'inversion de phase (T2) est inférieure à la valeur de seuil de commutation de courant du premier autre transistor (T3).

2. Montage suivant la revendication 1, caractérisé par le fait qu'entre les premier et second transistors (T3,T4) est prévue une sortie (A) du montage, à laquelle est raccordée une résistance de dérivation de forte valeur ohmique (R6) comportant un côté de raccordement libre pour le raccordement à la source (S) du transistor à effet de champ MOS (T5).

3. Montage suivant l'une des revendications précédentes, caractérisé par le fait qu'entre la base du collecteur du premier autre transistor (T3) est disposé un circuit série constitué par deux diodes (D3,D4) polarisées dans le même sens de telle sorte que la liaison entre la base du premier autre transistor (T3) et le collecteur du transistor d'entrée (T1) est établie par l'intermédiaire de l'une des diodes (par exemple D3).

4. Montage suivant l'une des revendications précédentes, caractérisé par le fait qu'entre la liaison de la base du second autre transistor (T4) et le collecteur du transistor d'inversion de phase (T2) est disposé un circuit série constitué de deux diodes (D1,D2) polarisées en des sens opposés, de telle sorte que le collecteur du transistor d'inversion de phase (T2) et la base du second autre transistor (T4) sont reliés par l'intermédiaire de l'une des diodes (par exemple 2) aux moyens adaptés (R4), à l'aide desquels une liaison est établie avec la tension associée d'alimentation (Uh2).

5. Montage suivant l'une des revendications précédentes, caractérisé par le fait qu'une résistance de limitation de courant à faible valeur ohmique (R5) est disposée dans la branche du collecteur du transistor d'entrée (T1) en étant associée directement au collecteur de ce transistor d'entrée (T1).

6. Montage suivant l'une des revendications précédentes, caractérisé par le fait que les deux autres transistors (T3,T4) sont formés par des transistors en montage de Darlington.

# FIG 1

UE = 5,5V . . . 15V

GT

E

A

D

G T5

S

L1

UA = 5V

D6

C3

0V

0V

# FIG 2

Uh1

R1

T3

Uh2

E

T1

R4

A

D

G T5

S

R2

T4

R6

D5

T2

R3

# FIG 3

# FIG 4